Europäisches Patentamt

European Patent Office

Office européen des brevets

(11) Veröffentlichungsnummer: **0 097 908**
**A1**

## (12) EUROPÄISCHE PATENTANMELDUNG

(21) Anmeldenummer: 83106051.2

(22) Anmeldetag: 21.06.83

(51) Int. Cl.³: **B 41 J 3/04**

(30) Priorität: 24.06.82 DE 3223636

(43) Veröffentlichungstag der Anmeldung:
11.01.84 Patentblatt 84/2

(84) Benannte Vertragsstaaten:
BE FR GB IT NL

(71) Anmelder: SIEMENS AKTIENGESELLSCHAFT
Berlin und München Wittelsbacherplatz 2
D-8000 München 2(DE)

(72) Erfinder: Lichti, Reiner, Dipl.-Ing.
Kerschensteinerstrasse 228
D-8034 Gemering(DE)

(54) Ansteuerschaltung für Piezowandler in Tintenmosaikschreibeinrichtungen.

(57) Die Erfindung betrifft eine Ansteuerschaltung für Piezowandler in Tintenmosaikschreibeinrichtungen.

Zur Ansteuerung eines Piezowandlers (1) in einer Tintenmosaikschreibeinrichtung ist ein aus einer Drossel (2) und
dem als Kapazität wirkenden Piezowandler (1) bestehender
Schwingkreis (1,2) vorgesehen, der durch Stromimpulse zu
einer Schwingung angestoßen wird, und dessen Schwingung, bezogen auf den Schwingungsanstoß durch ein
Dämpfungsglied (13, 14) zeitlich verzögert bedämpft wird.

FIG 4

EP 0 097 908 A1

SIEMENS AKTIENGESELLSCHAFT

Berlin und München

Unser Zeichen

VPA 82 P 1477 E

Ansteuerschaltung für Piezowandler in Tintenmosaikschreibeinrichtungen

Die Erfindung betrifft eine Schaltungsanordnung gemäß dem Oberbegriff des Patentanspruches 1.

Zur Ansteuerung von röhrenförmigen Piezowandlern für Schreibdüsen einer Tintenmosaikschreibeinrichtung ist es bekannt zur Einleitung eines Tröpfchenausstoßes die im Ruhezustand befindlichen Piezowandler durch Anliegen einer der Polarisationsrichtung des den Wandler bildenden piezokeramischen Elementes entgegengerichteten Spannung zu erweitern und dann anschließend durch Umpolung der Ansteuerspannung zu verengen (DE-AS 25 48 691). Die Erweiterung der Piezowandler führt dazu, daß eine kleine Tintenmenge angesaugt wird, während die Verengung den eigentlichen Tröpfchenausstoß bewirkt. Bei der bekannten Schaltung ist jedem Piezowandler ein Spannungswandler (Übertrager) zugeordnet, dessen Primärseite eine Impuls- und Verstärkerstufe enthält. Die sekundärseitige Induktivität des Übertragers bildet zusammen mit dem als Kapazität wirkenden Piezowandler einen Schwingkreis. Eine impulsweise Ansteuerung auf der Primärseite bewirkt nun, daß mit der Anstiegsflanke des Ansteuerimpulses auf der Sekundärseite ein Spannungsstoß induziert wird, der derart gepolt ist, daß sich der röhrenförmige Piezowandler erweitert. Nach dem Abschalten des Ansteuerimpulses, also mit dessen fallender Flanke wird eine Spannung in entgegengesetzter Richtung induziert, die eine Kontraktion des Piezowandlers auslöst. Die sekundärseitig entstehende Schwingung kann derart bedämpft werden, daß sie nach kurzer Zeit abklingt. Der Aufbau einer derartigen Ansteuerschaltung erfordert einerseits, bedingt durch die Verwendung eines Übertragers,

Fk 1 Obh / 22.6.1982

einen beträchtlichen Platzbedarf, der vor allem im Zuge einer ständigen Verkleinerung oder im Hinblick auf Entwicklungstendenzen zu Schreibköpfen mit einer größeren Anzahl von Schreibdüsen als nachteilig empfunden wird. Da die zum Antrieb von Piezowandlern in Tintenmosaikschreibeinrichtungen erforderlichen Spannungswerte am Piezowandler selbst Amplituden bis zu 300V aufweisen sollen, und diese Forderung mit Hilfe einer Schaltung mit Schwingungsverhalten gut erfüllt werden kann, ist man bestrebt, dieses Prinzip beizubehalten.

Aufgabe der Erfindung ist es, eine Schaltungsanordnung anzugeben, die bei erheblich reduziertem Platzbedarf die zur Ansteuerung von Piezowandlern erforderlichen Spannungswerte in der gewünschten Höhe zur Verfügung stellt, wobei zugleich die Kurvenform der am Piezowandler anliegenden Spannung in weiten Grenzen einstellbar ist und dimensioniert werden kann. Zugleich soll der Leistungsbedarf und die Temperaturabhängigkeit der Schaltungsanordnung gering sein.

Gelöst wird diese Aufgabe durch die im kennzeichnenden Teil des Patentanspruchs 1 angegebenen Maßnahmen.

Die wesentlichen Vorteile der angegebenen Schaltung beruhen neben einer deutlichen Platzersparnis und einer durch die Verwendung handelsüblicher und preiswerter Bauteile bedingten Kostenreduzierung darin, daß die Kurvenform des Ansteuerimpulses für den Piezowandler allein durch die Form des Ansteuerimpulses für den Schwingkreis eingestellt und dimensioniert werden kann. Da in der Ansteuerschaltung kein Übertrager vorgesehen ist, ergibt sich ein erheblich geringerer Leistungsbedarf. Schließlich wird die bei der bekannten Schaltung vor allem durch den Einsatz eines sogenannten Darlington Transistors bedingte Temperaturabhängigkeit ganz erheblich reduziert.

Durch die zeitlich verzögert wirksame Bedämpfung des Schwingkreises, wobei jeweils nur einzelne Halbwellen der Spannung des Schwingkreises bedämpft werden,wird die vorteilhafte Möglichkeit eröffnet, den zum Tröpfchenausstoß erforderlichen Spannungshub voll auszunützen und trotzdem ein rasches Abklingen der Schwingung zugewährleisten. Der Schwingkreis kann dabei, falls erforderlich, bis zum aperiodischen Grenzfall bekämpft werden.

Ausgestaltungen der Erfindung, wie sie in den Unteransprüchen gekennzeichnet sind, sehen vor, das Dämpfungsglied parallel zur Induktivität oder in Serie dazu anzuordnen. Bei Verwendung eines in Serie zur Induktivität des Schwingkreises geschalteten Dämpfungsgliedes ergibt sich der Vorteil einer deutlichen Erhöhung des Spannungshubs.

Schließlich wird gemäß weiterer Ausgestaltungen der Erfindung noch vorgesehen, die Ansteuerstufen jeweils über hochohmige Widerstände an die Spannungsversorgung anzuschliessen, womit der Vorteil einer zuverlässigen Überlastsicherung erreicht wird.

Einzelheiten der Erfindung werden im folgenden anhand der Zeichnungen erläutert. Dort zeigt

Fig. 1 ein Ausführungsbeispiel ohne Dämpfungsglied,

Fig. 2 einige Impulsdiagramme zur Erläuterung der Schaltung nach Fig. 1,

Fig. 3 ein Ausführungsbeispiel mit einer ersten Ausführung des Dämpfungsgliedes,

Fig. 4 ein Ausführungsbeispiel mit einer zweiten Ausführung des Dämpfungsgliedes,

Fig. 5 einige Impulsdiagramme zur Erläuterung der Schaltung nach Fig. 3 und Fig. 4,

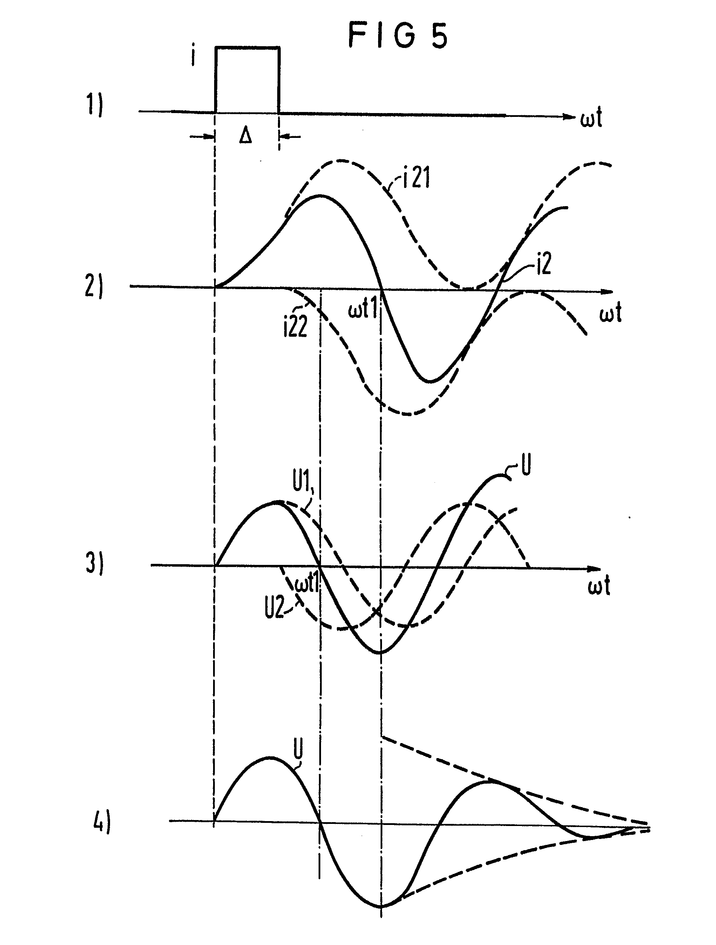

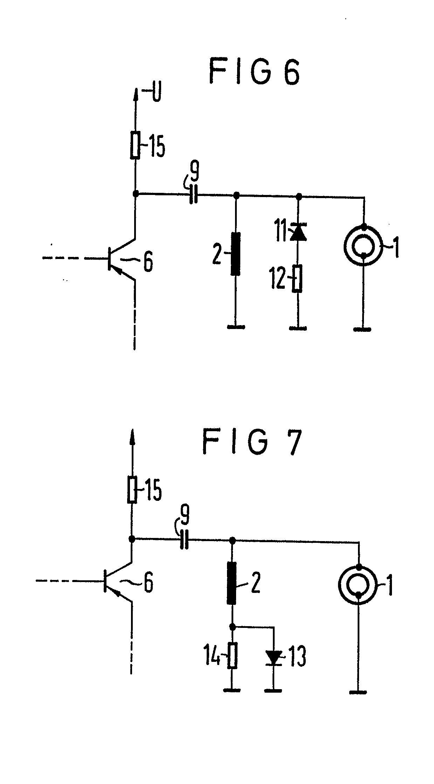

Fig. 5 und Fig. 6 Schaltungsbeispiele, die eine Sicherung gegen eine Überlastung gewährleisten.

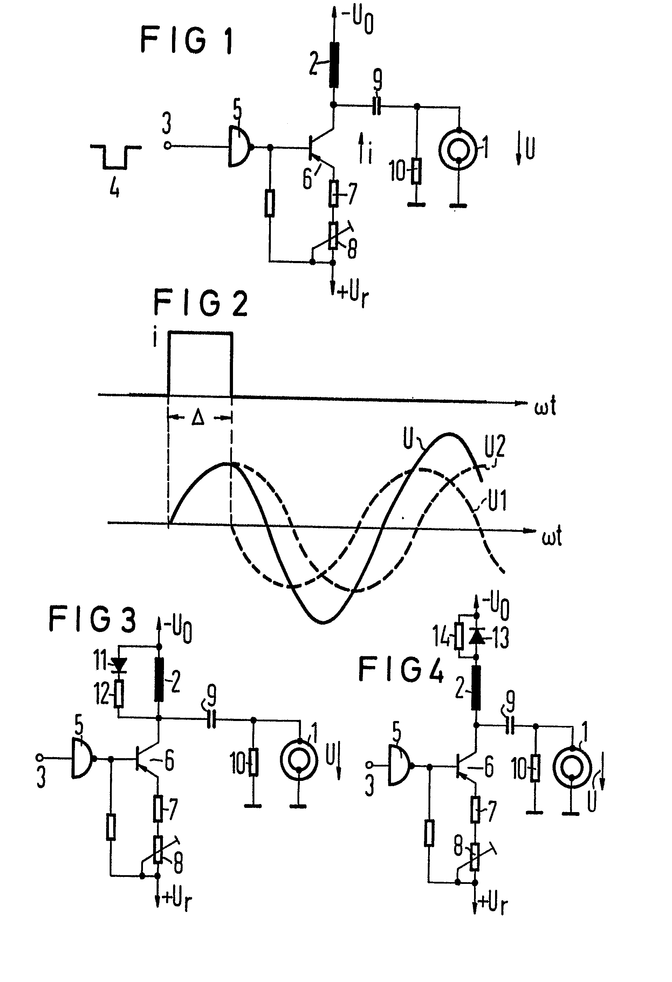

Fig. 1 zeigt das Beispiel einer Ansteuerschaltung für einen Piezowandler 1. Dieser bildet zusammen mit einer Induktivität 2 einen Parallelschwingkreis. Ein am Eingang 3 angelegter Steuerimpuls 4 steuert über ein sogenanntes Treiberelement 5 den Transistor 6 an, der als Stromquelle wirkt. Der vom Transistor 6 abgegebene Stromimpuls i, im Ausführungsbeispiel ein unipolarer Gleichstromimpuls, stößt den Schwingkreis 1, 2 an. Die Stromstärke des Stromimpulses i ist dabei durch die Widerstände 7 und 8 sowie durch die Referenzspannung Ur bestimmt. In einem praktischen Fall ergibt sich z.B. bei einer Versorgungsspannung -Uo=200V und einem positiven Anteil der Spannung U=200V am Piezowandler 1 für den Strom ein Wert i=14,1mA. Über den einstellbaren Widerstand 8, der in Fig. 1 im Emitterkreis des Transistors 6 angeordnet, der aber mit gleichem Vorteil auch im Basiskreis des Transistors 6 angeordnet sein kann, steht eine Einstellmöglichkeit zur Verfügung, die im Bereich von etwa 60V bis 300V (jeweils Uss) eine Regelmöglichkeit bietet. Ein Koppelkondensator 9, dessen Kapazität größer ist als die des Piezowandlers 1, dient zur Entkopplung des mit seiner einen Elektrode an Massepotential liegenden Piezowandlers 1. Zwischen dem Koppelkondensator 9 und dem Piezowandler 1 kann noch ein hochohmiger Widerstand 10 vorgesehen sein. Damit ist gewährleistet, daß der Piezowandler 1 im Ruhezustand sicher an Massepotential liegt.

Im Ausführungsbeispiel sind die Dauer $\triangle$ des Stromimpulses 4 und die Dimensionierung des Schwingkreises 1, 2 derart aufeinander abgestimmt, daß das erste Maximum der Schwingung nach Ablauf der Dauer $\triangle$ auftritt. Zu diesem Zeitpunkt wird bedingt durch das Abschalten des Gleichstromimpulses 4 eine zweite Schwingung angestoßen, die gegenüber der ersten Schwingung um die Dauer $\triangle$ phasenverschoben ist und umgekehrtes Vorzeichen aufweist. Diese Vorgänge ergeben sich aus der Betrachtung des Spannungsverlaufes an einen Parallelschwingkreis, der im zeitlichen Abstand der Dauer $\triangle$ mit Gleichstromimpulsen entgegengesetzter Polarität und unendlicher Länge beaufschlagt wird. Mit anderen Worten besteht die Betrachtung darin, daß man einen Ein- und einen Ausschaltvorgang durch zwei aufeinanderfolgende Einschaltvorgänge ersetzt. Beide Vorgänge überlappen sich zu einem unipolaren Gleichstromimpuls der Länge $\triangle$. Die beiden sich dabei ergebenden Spannungsverläufe stellen jeweils Sinusschwingungen dar, die sich im Ergebnis zu dem Spannungsverlauf am Parallelschwingkreis addieren.

Fig. 2 zeigt den Verlauf der Spannung am Schwingkreis 1, 2. Dort ist mit u1 der Spannungsverlauf, der beim Einschalten des Stromes i und mit u2 der Spannungsverlauf, der beim Ausschalten des Stromes i entsteht, bezeichnet. Der Verlauf der Spannungen u1 und u2 ist jeweils sinusförmig. Die Addition der beiden Spannungen u1 und u2 ergibt die Spannung U. Bei Vernachlässigung von dämpfenden Einflüssen entspricht die Spannung U bis zum Ablauf der Zeitdauer $\triangle$ der Spannung u1. Danach entspricht sie einer um 1/2$\triangle$ phasenverschobenen Cosinusschwingung.

Dieser Spannungsverlauf bewirkt, daß sich der Piezowandler bei Ansteuerung durch einen Stromimpuls definierter Länge zunächst erweitert, dann verengt und schließlich wieder erweitert. Für den praktischen Einsatz ist es zweckmäßig, die Schwingung in einer solchen Weise zu begrenzen, daß nach einer Verengung des Piezowandlers und damit nach dem Ausstoß eines Tröpfchens aus einem Tintenkanal, auf den der Piezowandler einwirkt, ein unkontrollierter Tröpfchenausstoß vermieden wird und daß das System sehr schnell den zur Einleitung eines weiteren Ausstoßvorganges erforderlichen Ruhezustand wieder einnimmt. Dazu wird im Rahmen der Erfindung vorgeschlagen, ein Dämpfungsglied der Induktivität des Schwingkreises parallel zu schalten (Fig. 3), oder das Dämpfungsglied in Serie zur Induktivität (Fig. 4) anzuordnen. Beiden Schaltungen gemeinsam ist das Merkmal, daß die dämpfende Wirkung nicht unmittelbar bei Beginn der Schwingung einsetzt, sondern verzögert zur Wirkung kommt. Das beruht darauf, daß im Verlauf des parallel geschalteten Dämpfungsgliedes (Fig. 3) der Spannungsverlauf einen Nulldurchgang aufweist; im Falle des in Serie geschalteten Dämpfungsgliedes (Fig. 4) weist der die Induktivität 2 durchfließende Strom eine Richtungsumkehr auf, da dessen Verlauf dem durch die Überlagerung des durch den Einschalt- und den Ausschaltvorgang des Stromimpulses 4 bewirkten Stromverlauf entspricht.

Zur Erläuterung wird auf die Darstellung in Fig. 5 verwiesen, der das Beispiel eines in Serie geschalteten Dämpfungsgliedes zugrunde liegt. Dort ist in der ersten Zeile ein Gleichstromimpuls i der Dauer $\triangle$ dargestellt. Zeile 2 zeigt den Stromverlauf über die Induktivität 2, wobei mit i21 der beim Einschalten und mit i22 der beim Abschalten des Gleichstromimpulses auftretende Stromverlauf bezeichnet ist. Durch Überlagerung der beiden Ströme i21 und i22 ergibt sich der über die Induktivität 2 fließende Strom i2. Dieser wechselt zum Zeitpunkt $\omega$t2 seine Richtung. Zum gleichen Zeitpunkt hat, wie in Zeile 3 dargestellt ist, die Spannung U, die wie bereits vorher beschrieben, durch die Überlagerung der beiden Spannungen u1 und u2 gebildet ist, das erste negative Maximum erreicht. Ab diesem Zeitpunkt wird die Diode 13 (Fig. 4) des Dämpfungsgliedes gesperrt. Damit wird der Dämpfungswiderstand 14 (Fig. 4) wirksam in den Stromkreis geschaltet. Die Funktion bei Einsatz eines parallel geschalteten Dämpfungsgliedes ist ähnlich. Da, worauf vorher hingewiesen wurde, die Spannung U einen Nulldurchgang aufweist (Zeitpunkt $\omega$t1 in Fig. 5, Zeile 3) wird die dämpfende Wirkung bereits zu diesem Zeitpunkt wirksam.
Das führt dazu, daß, was in Fig. 5 nicht dargestellt ist,
die erste negative Halbwelle einer Schwingung bedämpft wird.
Durch geeignete Dimensionierung der Widerstände 12 bzw. 14
(Fig. 3,4) kann ein Spannungsverlauf, wie in Fig. 5, Zeile 4
für den Fall, des in Serie geschalteten Dämpfungsgliedes
dargestellt ist, erzeugt werden. Die Dämpfungswiderstände 12
bzw. 14 können auch derart dimensioniert sein, daß der sogenannte aperiodische Grenzfall eintritt und die Schwingung ohne ein Überschwingen ausklingt.

Mit den angegebenen Schaltungen lassen sich Spannungsamplituden erzielen, die erheblich über dem Wert der Versorgungsspannung Uo liegen. Beispielsweise werden bei einer Versorgungsspannung Uo=200V eine Gesamtamplitude (Uss) von mehr
als U=300V erreicht. Bei Anwendung der anhand von Fig. 4
beschriebenen Seriendämpfung kann eine Gesamtamplitude
von U=300V bereits mit einer Versorgungsspannung von Uo=125V
erzielt werden. Eine Schaltung mit serieller Dämpfung
(Fig. 4) ist auch hinsichtlich des Leistungsbedarfs günstiger als eine Schaltung mit parallelgeschaltetem Dämpfungsglied (Fig. 3).

Zur Erhöhung der Sicherheit für den Fall eines Kurzschlusses des Transistors 6 oder des Koppelkondensators 9 wird
im Rahmen der Erfindung vorgeschlagen, im Kollektorkreis
des Transistors 6 einen hochohmigen Widerstand vorzusehen.
Ausführungsbeispiele dazu zeigen Fig. 6 und 7. Dort ist
der entsprechende Widerstand mit 15 bezeichnet. Hinsichtlich seiner Dimensionierung ist sicherzustellen, daß nach
jedem Spritzvorgang der Koppelkondensator 9 wieder vollständig aufgeladen wird. Die Funktionsweise dieser Schaltungen entspricht der im vorhergehenden beschriebenen
Funktionsweise.

6 Patentansprüche 6 Figuren

Patentansprüche

1. Schaltungsanordnung zur Ansteuerung von die Schreibdüsen in Tintenmosaikschreibeinrichtungen zylinderförmig umfassenden Piezowandlern, deren Durchmesser sich bei Anlegen einer entgegen der Polarisationsrichtung der Piezokeramik des Wandlers gepolten Spannung erweitert, bei Anlegen einer entgegengesetzt gepolten Spannung verengt, wobei die Spannung am Piezowandler mit Hilfe eines aus einer Induktivität und dem Piezowandler als Kapazität bestehenden Schwingkreis gebildet wird, dadurch gekennzeichnet, daß der aus dem Piezowandler (1) und einer Drossel (2) als Induktivität bestehende Schwingkreis (1,2) unmittelbar über einen Stromimpuls (i) bestimmter Länge ( ) angestoßen wird, daß die Kurvenform des Spannungsverlaufs (U) des Schwingkreises (1,2) durch die Form des Stromimpulses (i) bestimmt ist, und daß ein Dämpfungsglied (11,12) bzw. (13,14) vorgesehen ist, das gegenüber dem durch den Stromimpuls (i) eingeleiteten Schwingungsbeginn des Schwingkreises (1,2) zeitlich verzögert wirksam ist und den Spannungsverlauf (U) des Schwingkreises (1,2) zeitlich verzögert bedämpft.

2. Anordnung nach Anspruch 1, dadurch gekennzeichnet, daß dem Schwingkreis (1,2) ein aus einem stromrichtungsabhängigen Schaltelement (11) und einem Dämpfungswiderstand (12) bestehendes Dämpfungsglied parallel geschaltet ist, das jeweils nach dem ersten Nulldurchgang einer Schwingung wirksam ist.

3. Schaltungsanordnung nach Anspruch 1, dadurch gekennzeichnet, daß in Serie zur Induktivität (2) des Schwingkreises (1,2) ein aus einem stromrichtungsabhängigen Schaltelement (13) und einem diesem parallel geschalteten Dämpfungswiderstand (14) bestehendes Dämpfungsglied vorgesehen ist, das jeweils nach dem zweiten Maximum einer Schwingung wirksam ist.

4. Schaltungsanordnung nach einem der Ansprüche 1 bis 3, d a d u r c h   g e k e n n z e i c h n e t , daß zur Einstellung der Stromstärke des Stromimpulses (1) im Emitterkreis des Transistors (6) ein einstellbarer Widerstand (8) vorgesehen ist.

5. Schaltungsanordnung nach einem der Ansprüche 1 bis 3, d a d u r c h   g e k e n n z e i c h n e t , daß zur Einstellung der Stromstärke des Stromimpulses (1) im Basiskreis des Transistors (6) ein einstellbarer Widerstand vorgesehen ist.

6. Schaltungsanordnung nach einem der Ansprüche 1 bis 5, d a d u r c h   g e k e n n z e i c h n e t , daß im Kollektorkreis des Transistors (6) ein hochohmiger Widerstand (15) vorgesehen ist, und daß zwischen diesem Widerstand (15) und dem Kollektoranschluß des Transistors (6) der aus Induktivität (2) und dem Piezowandler (1) bestehende Schwingkreis sowie das Dämpfungsglied (11,12) bzw. (13,14) angeschlossen ist.

FIG 1

FIG 2

FIG 3

FIG 4

0097908

1/3

# FIG 5

3/3

FIG 6

FIG 7

0097908
Nummer der Anmeldung

**Europäisches Patentamt**

**EUROPÄISCHER RECHERCHENBERICHT**

## EINSCHLÄGIGE DOKUMENTE

EP 83106051.2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | DE - A1 - 3 036 922 (SIEMENS)  \* Fig. 1; Seiten 6,7 \* | 1 | B 41 J 3/04 |
| A | DE - A1 - 3 039 164 (CANON)  \* Fig. 2A \* | 1 | |
| D,A | DE - B2 - 2 548 691 (SIEMENS) | | |

| RECHERCHIERTE SACHGEBIETE (Int. Cl. ³) |
|---|
| B 41 J 3/00 |
| G 01 D 15/00 |
| G 06 K 15/00 |

Der vorliegende Recherchenbericht wurde für alle Patentansprüche erstellt.

| Recherchenort | Abschlußdatum der Recherche | Prüfer |
|---|---|---|
| WIEN | 01-10-1983 | WITTMANN |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : In der Anmeldung angeführtes Dokument
L : aus andern Gründen angeführtes Dokument

& : Mitglied der gleichen Patentfamilie, übereinstimmendes Dokument

EPA Form 1503. 03.82